# EUROPEAN PATENT SPECIFICATION

(11) **EP 3 025 194 B1**
(45) Date of publication and mention of the grant of the patent: **26.01.2022**
(21) Application number: 14742345.3
(22) Date of filing: 21.07.2014
(51) Int. Cl.: G03F 1/00, G03F 1/20, G03F 7/20

(54) **METHOD OF FORMING A DESIRED PATTERN ON A SUBSTRATE**
VERFAHREN ZUR BILDUNG EINES GEWÜNSCHTEN MUSTERS AUF EINEM SUBSTRAT
PROCÉDÉ DE FORMATION D'UN MOTIF SOUHAITÉ SUR UN SUBSTRAT

(30) Priority: 22.07.2013 GB 201313054
(43) Date of publication of application: 01.06.2016
(73) Proprietor: Vestlandets Innovasjonsselskap AS, 5006 Bergen (NO)
(72) Inventor: HOLST, Bodil, 5652 Aarland (NO)
(74) Representative: Dehns
(86) International application number: PCT/GB2014/052224
(87) International publication number: WO 2015/011457

(56) References cited:
- SANZ R ET AL: "Patterning of rutile TiO2 surface by ion beam lithography through full-solid masks", NANOTECHNOLOGY, IOP, BRISTOL, GB, vol. 21, no. 23, 11 June 2010 (2010-06-11) , pages 1-6, XP020174970, ISSN: 0957-4484
- SKUPIAA SKI M ET AL: "Nanopattern transfer to SiO2 by ion track lithography and highly selective HF vapor etching", JOURNAL OF VACUUM SCIENCE AND TECHNOLOGY: PART B, AVS / AIP, MELVILLE, NEW YORK, NY, US, vol. 25, no. 3, 11 May 2007 (2007-05-11), pages 862-867, XP012102970, ISSN: 1071-1023, DOI: 10.1116/1.2738481
- RAZPET ALENKA ET AL: "Fabrication of high-density ordered nanoarrays in silicon dioxide by MeV ion track lithography", JOURNAL OF APPLIED PHYSICS, AMERICAN INSTITUTE OF PHYSICS, US, vol. 97, no. 4, 25 January 2005 (2005-01-25), pages 1-4, XP012070696, ISSN: 0021-8979, DOI: 10.1063/1.1850617
- REISINGER THOMAS ET AL: "Neutral atom and molecule focusing using a Fresnel zone plate", JOURNAL OF VACUUM SCIENCE AND TECHNOLOGY: PART B, AVS / AIP, MELVILLE, NEW YORK, NY, US, vol. 26, no. 6, 1 December 2008 (2008-12-01), pages 2374-2379, XP012114476, ISSN: 1071-1023, DOI: 10.1116/1.2987955
- REHN L E ET AL: "Self-organized porous-alumina implantation masks for generating nanoscale arrays", NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, vol. 206, 1 May 2003 (2003-05-01), pages 490-494, XP004425869, ISSN: 0168-583X, DOI: 10.1016/S0168-583X(03)00805-X

## Description

The present invention relates to a method of forming a desired pattern (structure) on a substrate comprising using an atomic or molecular beam, in particular a He atom beam, and a mask having a desired pattern such as a Fourier transform of the desired pattern on the substrate. The patterned mask is prepared by a method comprising providing a porous starting mask material having openings of a size which allow the atomic or molecular beam to penetrate through and creating the desired pattern on the mask by filling a proportion of the openings of the mask which thereby become non-transparent for the atomic or molecular beam. The method of present invention can be used for preparing conducting circuit structures (micro-chips) or microelectromechanical systems (MEMS) or structures for micro/nano fluidics or nanostructured surfaces, ie. hydrophobic or hydrophilic or reflective/antireflective surfaces.

### Background of the Invention

Lithography can be split into two major classes: maskless lithography and mask lithography. A further distinction can be made between lithograpy based on beams (ie. photolithography or electron beam lithography) and lithography based on solid probes (ie. scanning probe lithography). The present invention is concerned with beam-based mask lithography.

Two types of lithography are here relevant: contact/near vicinity lithography, where the mask is in contact with or very close to the surface to be patterned, so that no diffraction between the mask and the beam takes place, or "normal" lithography where the geometry of the setup corresponds to the Fraunhofer diffraction regime, so that the pattern is created in a diffraction process between the mask and the beam. Depending on the setup chosen the pattern is either a direct image of the mask or a diffraction pattern of the mask (equivalent to the Fourier transform of the mask).

For contact/near vicinity lithography the pattern resolution is determined by the minimum feature size of the mask. The problem with this type of lithography is that for mass-production processes it is complex to bring the mask and the surface close to each other repeatedly and fast. Hence in the semiconductor industry and elsewhere, where mass-production is required, the pattern is almost always created through a diffraction process. The beam used is always a photonic beam (laser). Electron beams and ion beams are used mainly in maskless lithography (among others to make masks for photolithography). Atom or molecule based techniques have so far not been able to compete on a commercial basis.

The ultimate resolution limit of beam-based mask lithography operating in the Fraunhofer regime, assuming that the patterning beam is perfectly coherent, is determined by the wavelength of said patterning beam through the Rayleigh or Abbe criterion. The development of higher resolution methods has been going on continuously for years. The state of the art for commercial applications in the semiconductor industry is presently around 20 nm. The next generation Extreme Ultra Violet (EUV) lithography is expected to deliver 10 nm resolution or less. However, this happens at enormous cost in the production of the lithography devices (hundred million dollars and more) and there are still severe challenges associated with finding suitable mask materials and resist for such high photon energies.

Atom lithography has been pursued for several years as a potential alternative to photo-lithography. The main advantage of atom lithography is that the energy of an atom for a particular wavelength is several orders of magnitude smaller than the energy of a photon for a similar wavelength. The demand on mask materials and resists are thus considerably lower. However, up till now the basic principle for creating the masks for atom lithography has been similar to those applied to photolithography, with the additional restriction that the masks for atom lithography have to be partially transparent to the atoms and hence cannot be placed on a solid support structure. This has limited the resolution.

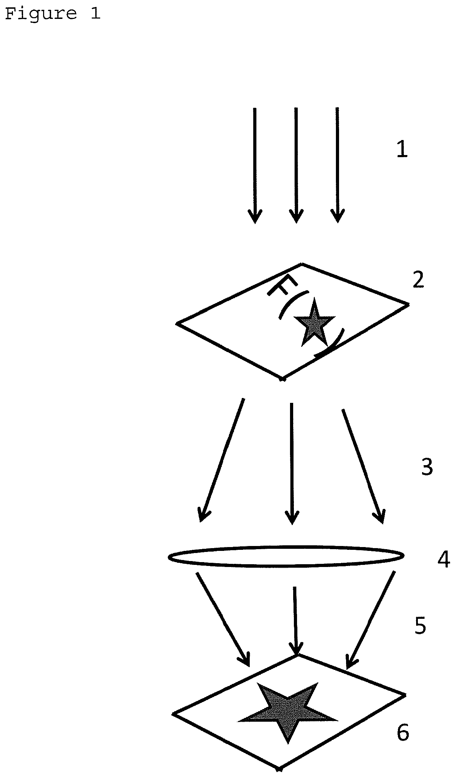

In 1996, Fujita et *al.* (J. Fujita, M. Morinaga, T. Kishimoto, M. Yasuda, S. Matsui, and F. Shimizu. Manipulation of an atomic beam by a computer-generated hologram. Nature, 380:691694, 1996) demonstrated how a predefined pattern could be imaged by a beam of metastable neon atoms by use of a binary, computer generated hologram (a Fourier transform of the pattern to be generated) as mask (a 2D membrane with holes). Figure 1 of this reference shows the principle behind the Fourier hologram.

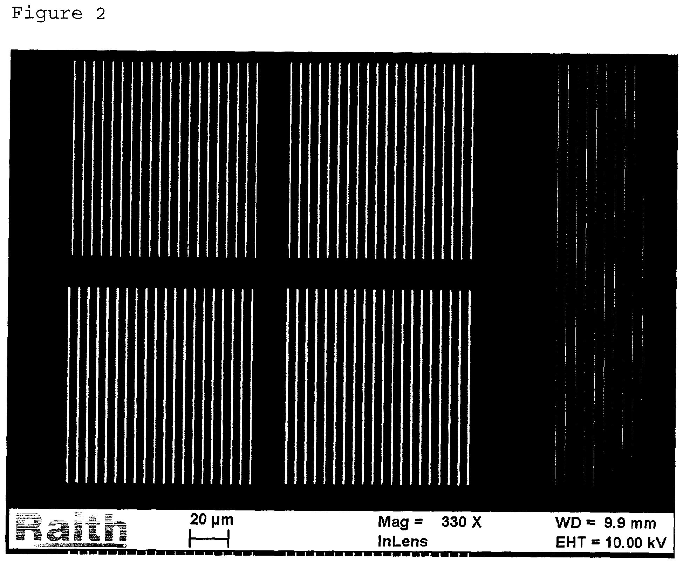

Following the general theory of binary holograms as described in Lohmann et *al.* (A W. Lohmann and D. P. Paris. Binary Fraunhofer Holograms, Generated by Computer. Applied Optics, 6:17391748, 1967), the maximum resolution is determined by the minimum hole size/minimum hole periodicity. The hologram mask used by Fujita et *al.* was made by electron beam lithography patterning of a SiN membrane followed by etching, an image of the mask can be seen in Figure 2 of Fujita et *al.* In the experiment the pattern was recorded by 2D detection of the neon atoms, but in principle it could just as well have been transferred to a substrate in a lithography process.

Sanz et *al.* (R. Sanz, M. Jaafar, M. Hernandez-Velez, A. Asenjo, M. Vázquez, J. Jensen: Patterning of rutile TiO2 surface by ion beam lithography through full-solid masks. Nanotechnology, 21: 235301, 2010) discloses the nanopatterning of rutile TiO₂ single crystal surfaces following their irradiation with energetic heavy ions through a stencil mask of Ni filled self-ordered porous anodic alumina.

In accordance with the discussion hereinabove, it is an object of the present invention to provide suitable masks and methods for making same for use in beam-based lithography, in particular atomic or molecular beam-based lithography, said masks having a pattern, formed by filling a proportion of the openings of the mask, in dimensions which allow one to form patterns (structures) on a substrate of interest by using an atomic or molecular beam, in particular by operating in the Fraunhofer regime, have not been described in the prior art. Desirably, the dimensions of the pattern on the mask are such that patterns (structures) having dimensions in the range from Angstroms to nanometers can be formed on a substrate of interest such as a semiconductor-based substrate.

### Summary of the Invention

The above object(s) are solved by a method of forming a desired pattern on a substrate comprising the steps of
a) generating an atomic or molecular beam;
b) providing a mask having a desired pattern;
c) directing the atomic or molecular beam through the patterned mask onto a substrate, whereby a pattern is formed on the substrate by interaction with the proportion of the atomic or molecular beam which penetrates through the mask, which pattern is based on the pattern of the mask,
   wherein the patterned mask is prepared by a method comprising
d) providing a porous starting mask material having openings of a size which allow the atomic or molecular beam to penetrate through;
e) creating the desired pattern on the mask by filling a proportion of the openings of the mask which thereby become non-transparent for the atomic or molecular beam.

In the methods herein described the desired patterning of the mask is achieved by occlusion of a proportion of the pores, openings or channels of the porous starting mask material. Thus the term "filling" is intended to be broadly construed to cover both blocking (whether partial or complete) and covering of the pores, openings or channels in the mask material.

Preferred embodiments of the invention are disclosed in the appended claims.

### Detailed Description of the Invention

According to one embodiment of the present invention, the atomic or molecular beam generated in step (a) comprises one of the following: He atoms or any other noble gas atoms (as discussed in K. K. Berggren, A. Bard, J. L Wilbur, J. D. Gillaspy, A. Helg, J. J. Mcclelland, S. L. Rolston, W. D. Phillips, M. Prentiss, G. M. Whitesides. Microlithography by using neutral, metastable atoms and self-assemble monolayers. Science, 269: 1255, 1995; S. Nowak, T. Pfau, J. Mlynek: Nanolitohgraphy with metastable helium. Appl. Phys. B., 63: 203, 1996; S. Rehse, A. Glueck, S. A. Lee, A. B. Goulaov, C. S. Menoni, D. C. Ralph, K. S. Johnson and M. Prentiss: Nanolithography with metastable neon atoms: Enhanced rate of contamination resist formation for nanostructure fabrication. Appl. Phys. Lett., 71: 1427, 1997; P. Engels, S. Salewski, H. Levsen, K Sengstock and W. Ertmer: Atom Lithography with a cold, metastable neon beam. Appl. Phys. B., 69: 407, 1999), in particular metastable noble gas atoms, alkali metals (as discussed in M. Kueis, F. Lison, D. Haubrich, D. Meschede, S. Nowak, T. Pfau, J. Mlynek: Pattern generation with cesium atomic beams at nanometer scales. Appl. Phys. B., 63: 649, 1996), alkaline metals (as discussed in E. Arimondo:. Laser controlled nanodeposition of neutral atoms. Appl. Surf. Sci., 248: 167, 2005) and group III elements (as discussed in A. Camposeu, O. Marago, B. Fazio, B. Kloeter, D. Meschede, U. Rasbach, C. Weber and E. Arimondo: Resist-assisted atom lithography with group III elements. Appl. Phys. B. 85: 487, 2006), or energetic, neutral atoms, in particular oxygen or nitrogen atoms (as described in US-A-2007/0114207 and E. A. Akhadov, D. E. Read, A. H. Mueller, J. Murray, and M. A. Hoffbauer: Innovative approach to nanoscale device fabrication and low-temperature nitride film growth, J. Vac. Sci.Technol. B 23 (6), 3116-31 19 (2005)), H₂ molecules, N₂ molecules, preferably He atoms, in particular metastable He atoms.

As used herein, the terms "atoms" or "molecules" also relate to those species which carry a charge, i.e. ions of atoms and molecules, and which may be manipulated (reflected, focused) by using the devices and methods of the present invention.

As discussed in EP 2 061 039 A1 (W. Allison et al.)*,* Helium (He) atom scattering is a powerful, well-established technique for investigating the structural and dynamical properties of surfaces, as it is described e.g. in E. Hulpke (Ed.) 1992, Helium Atom Scattering from Surfaces, Springer Series in Surface Sciences Vol. 27, Springer (Berlin); D. Farias and K.H. Rieder, Rep. Prog. Phys. 61, 1575 (1998) or G. Bracco and B. Holst, Eds. in Springer Series in Surface Science, Springer 2013, Chapter 12, pages 333-367.

Specifically, the atomic beam generated in step (a) has a spatial coherence length corresponding to the extension of the mask and a wavelength distribution which is small relative to the desired pattern resolution (typically the pore size of the mask). This can be obtained for example by applying light fields (laser cooling and laser collimating techniques) to the atomic beam and/or mechanical velocity selection based on beam chopping (Time of Flight) or the use of a solid structure (a diffracting transmission grating or a diffracting surface) or electrostatic or magnetic fields. Ultimately a perfectly coherent assembly of atoms can be obtained with a Bose Einstein condensate, which can be used to create an atom laser. This methodology is discussed, for example, in DE 203 20 085 U1.

The position of the substrate plane can be adjusted as desired, and the resolution improved by inserting an atom lens or focussing mirror in the beam path before or after the mask so that the virtual source plane (defined as the plane where all atoms trajectories can be backtraced to with the minimum spatial extension) and the substrate planes are conjugate planes. For further background information and a proof of this concept see M. Born, E. Wolf, Principles of Optics, Pergamon Press 1970. The atom lens or focussing mirror can be either made with light fields or electrostatic/magnetic fields or a solid material.

A suitable set-up of a He atom scattering apparatus is shown in Figure 1.

More specifically, with respect to Figure 1, (1) is a collimated atomic beam, here shown as a parallel beam corresponding to a point source at infinity. (2) is a binary holography mask produced according to the method described in the present application. In the embodiment shown in Figure (1), the mask gives the Fourier transform F(*) of a desired final pattern (*) on the substrate. The setup shown in Figure 1 is in the Fraunhofer regime which means that the atomic beam is diffracted (3) by the binary holography mask. Note the arrows here are just schematic and do not represent the same rays as in (1). Optionally, an atom lens (4) can be placed before or after the binary holography mask and can be made either with light fields or as a solid structure (for example a nano-fabricated Fresnel Zone plate). The (optional) atom lens projects the atom diffraction pattern onto the substrate plane. Note the arrows here are just schematic and do not represent the same rays as in 1 and 3. The final pattern (*) (6) is the Fourier transform of the binary Holography mask pattern, projected onto a substrate. If a lens/focussing mirror is used, the substrate is best placed so that the source plane and substrate plane are conjugate planes (the focal length of the lens/focussing mirror and the overall geometry is so that the lens/focussing mirror images the source onto the substrate plane).

### Substrates

According to one embodiment of the present invention, when or after the desired pattern is formed on the substrate, the substrate may be subjected to one or more further processing steps subsequent to step (c), for example one or more chemical treatment steps such as etching. Thereby, desired structures based on the pattern formed on the substrate can be generated.

For example, the substrate may comprise one or more resist layers for creating the desired pattern by interaction with the proportion of the atomic or molecular beam which penetrates through the mask and, optionally, one or more intermediate layers on the substrates such as metal layers or oxide layers, in particular SiO₂. In particular, the proportion of the resist layer(s) that has interacted with the proportion of the atomic or molecular beam which penetrates through the mask and, optionally, the one or more intermediate layers may be subjected to etching.

With regard to the composition of the resist layer, said layer may be a hydrophobic resist layer comprising organic molecules sensitive to interaction with the proportion of the atomic or molecular beam which penetrates through the mask. In particular, the resist layer may comprise self-assembled monolayers of organic molecules, ie. hydrocarbon-based molecules such as thioles or thiolates, for example alkanethioles such as nonanethiol or dodecanethiol, or an alkanethiolate such as decanethiolate, or silicon compounds such as siloxanes such as alkylsiloxanes, alkylarylsiloxanes or alkylhalosiloxanes, for example trimethylpentaphenyl-trisiloxane, octadecylsiloxane, or based on octadecyltri-chlorosilane. These compounds are discussed, for example, in Y. Xia, Z. M Zhao,E. Kim and G. Whitesides: A selective etching solution for use with patterned self-assembled monolayers of alkanetiolates on gold. Chem. Mater., 7: 2332, 1995; K. S: Johnson, K. K. Berggren, A. Black, C.T. Black, A. P. Chu, N. H. Dekker, D. C. Ralph, J. H. Thywissen, R. Younkin, M. Tinkham, M. Prentiss and G. M. Whitesides. Using neutral metastable argon atoms and contamination lithography to form nanostructure in silicon, silicon dioxide and gold. Appl. Phys. Lett. 69: 2773, 1996; S. B. Hill, C. A. Haich, F. B. Dunning, G. K Walters, J. J. McClelland, R. J. Celotta, H. G. Craighead, J. Han and D. M. Tannenbaum: Patterning of octadecylsiloxane self-assembled monolayers on Si(100) using Ar(3P0,2) atoms. J. Vac. Sci. Technol. B, 17: 1087, 1999; W. Lu, K. Baldwin, M. Hoogerland, S. Buckman, T. J. Senden, T. E: Sheridan, R. W. Boswell: Sharp edged silicon structures generated using atom lithography with metastable helium atoms. J. Vac. Sci. Technol. B, 16:3846, 1998; J. Zhang, M. Kurahashi, T. Suzuki, X. Sun, Y. Yamuchi: Microfabrication of silicon using self-assembled monolayer resist and metastable helium beam. Jpn. J. Appl. Phys., 45(10A): 8020, 2006 or Berggren et *al.* already referenced above.

With regard to the composition of the substrate, said substrate may suitably be selected from the group consisting of semiconductors, glass materials, metals and combinations thereof. For example, the substrate is a silicon or GaAs wafer.

### Masks

In the lithography processes described in the prior art, a membrane of a non-transmissive material is usually used as base template for the mask. The patterned (structured) mask is then created by making holes in the membrane using for example electron beam lithography and reactive ion etching.

In another lithography process (R. Sanz, M. Jaafar, M. Hernandez-Velez, A. Asenjo, M. Vázquez, J. Jensen: Patterning of rutile TiO2 surface by ion beam lithography through full-solid masks. Nanotechnology, 21: 235301, 2010), a mask is created by filling all of the pores of a porous anodic alumina membrane (PAA) by electrodeposition of Ni. A nanostructure is formed on a TiO₂ substrate using a 25 MeV Br ion beam. Patterning relies on the different densities of the Ni and PAA and thus their different ion stopping powers when subjected to the high energy ion.

In contrast to the procedures used in the prior art, according to the present invention, the base mask template (mask starting material) is a porous material such as a porous membrane, where the openings (pores, holes) are large enough to allow the beam to penetrate. The mask is created, not by making holes or filling all of the holes, but by filling a proportion of the holes. Thereby, it is possible to arrive at patterns that do not suffer from the disadvantages of the prior art and to enhance the resolution of the lithographic method by preparing a mask having a pattern with dimensions down to the atomic scale, ie. in the Angstrom range.

In particular, the starting material for preparing the mask may be selected from the group consisting of graphene, silicates having a channel structure, for example SiO₂, beryl, zeolites, zircon or other types of sheet- or framework- or neo-silicates, metal-organic frameworks, two-dimensional porous protein crystals, mesoporous silica with open pores up to a few tenths of nanometers, anodic aluminium oxide, and other oxides and glasses such as silicate and network glasses (with open pores in the range from angstrom to a few tenths of nanometers). Nanofabricated porous methods can also be used, for example nuclear track etched nanoporous membranes, or lithography methods, including the method described in WO 2010/085337 A1.

According to preferred embodiments, the starting mask material is prepared by one of the following methods:
i) thinning down of bulk materials by mechanical polishing and/or chemical polishing and/or sputtering followed by patterning or alternatively first patterning and then thinning down;
ii) the creation of free standing thin films in a Langmuir Blodgett or similar fashion;
iii) the growth of a thin film on a substrate, wherein the substrate is removed before or after creating the desired pattern according to step (e) of claim 1;
iv) the pulling of bundles of glass capillary tubes followed by thinning down by mechanical polishing and/or chemical polishing and/or sputtering followed by patterning or alternatively first patterning and then thinning down.

A suitable starting mask material is the structure shown in Figure 3 of Lichtenstein et *al.* (L. Lichtenstein, M. Heyde, and H.-J.Freund. Crystalline-Vitreous Interface in Two Dimensional Silica. Physical Review Letters, 109:106101, 2012). The figure is an STM picture of a single atomic layer of SiO₂ showing the transition from crystalline (quartz) to vitreous (glass) which can be controlled by the growth mode. For a lithography mask one would preferably make a large area purely crystalline. Figure 3 of Lichtenstein et *al.* also presents the same STM picture with an atomic model on top which illustrates the porous structure obtained. The periodicity in the crystalline part is about 0.5 nm, the open pore slightly smaller. A mask based on this material can be made for example by patterning the thin film and subsequently removing the substrate in the central area, leaving a crystalline, nanopatterned film on a frame.

In the method according to the present invention, focussed ion beam induced deposition, focussed electron beam induced deposition, focussed ion deposition or scanning probe lithograpy or a seeded molecular beam or optical tweezers is used for filling a desired proportion of the openings (pores) contained in the starting mask material thereby creating the desired pattern. The size of the openings in the starting mask material is in the range from Angstrom to sub-micrometer, determined by the structure of the chosen mask material as discussed above.

According to one embodiment of the present invention, the starting mask material may be based on a quartz film grown on the surface of a metallic substrate, preferably a single-crystalline metallic substrate in particular on the (0001) surface of a noble metal such as ruthenium.

The thickness of thin films which may be used as starting materials may range from a single atomic layer to several micrometers depending on the desired pattern resolution.

With regard to the patterns to be formed on the mask and substrate, according to one embodiment of the present invention, the desired pattern of the mask is a Fourier transformation of the desired pattern on the substrate.

### Atomic/Molecular Beams

Beams based on helium or other noble gasses or hydrogen are preferred because they are the smallest molecules and electrically neutral so that charging of the mask is not an issue. In particular, in a method of the present invention based on a mask material derived from the structure shown in Figure 3 of Liechtenstein et al., a beam based on metastable He may be used.

Metastable helium has been used in several atom lithography experiments. The patterning process takes place when the helium decays upon hitting the substrate thus depositing its 20 eV energy. A hydrophobic resist layer created by self assembled monolayers of nonanethiol has been used. It was locally damaged by the metastable helium atoms and then removed in a wet etching process, as discussed in S.J.H.Petra et al. (S. J. H. Petra, K. A. H. Van Leeuwen, L. Feenstra, W. Hogervorst, W. Vassen. Atom lithography with two-dimensional optical masks. Applied Physics B, 79:279283, 2004).

Particular advantages of using a metastable helium beam are that the exited state energy is very high (20 eV), the life time long (about 8000s), as discussed by Baldwin (K. G. H. Baldwin. Metastable helium: atom optics with nano-grenades. Contemporary Physics, 46:105120, 2005), and helium does not absorb on any substrate, so that even helium atoms decaying upon the interaction with the mask will not clog it.

### Applications

The method of the present invention is useful for preparing conducting circuit structures (micro-chips) or microelectromechanical systems (MEMS) or structures for micro/nano fluidics or nanostructured surfaces in general, ie. hydrophobic or hydrophilic surfaces or reflective/antireflective surfaces.

The invention will now be described with reference to the following non-limiting example:

### Example

A mask was produced by patterning a quartz-membrane substrate (a-quartz (0001) orientation). The pattern was obtained by first coating the quartz-membrane with an approx. 25 nm thick chrome layer using electron beam evaporation, followed by a 160 nm thick PMMA resist layer applied with spin coating. At this stage all pores/channels/holes are blocked. The pattern was then written using electron beam lithography (using a Raith e-line instrument). After patterning the chrome was removed from the patterned area (and the quartz pores/channels/holes un-blocked) using Transene Company Inc. "Chromium etchant 1020" for about 20 seconds at a temperature of 20°C (see http://transene.com/cr/).

The resulting pattern is shown in Figure 2. It is arbitrary, consisting of lines of different widths (around 250, 330, 460, 480 nm and some longer lines with a width of around 90 nm) with a periodicity of about 5 micron for all line widths. As will be appreciated, the detailed specification for line widths and periodicity do not represent any limits on the potential resolution of the masks which can be produced according to the methods herein described.

### Patent references cited in the present application

- EP 2 061 039 A1
- US 2007/0114207 A1
- WO 2010/085337 A1
- DE 203 20 085 U1

### Non-patent references cited in the present application

- J. Fujita, M. Morinaga, T. Kishimoto, M. Yasuda, S. Matsui, and F. Shimizu. Manipulation of an atomic beam by a computer-generated hologram. Nature, 380:691694, 1996
- A W. Lohmann and D. P. Paris. Binary Fraunhofer Holograms, Generated by Computer. Applied Optics, 6:17391748, 1967
- E. Hulpke (Ed.). Helium Atom Scattering from Surfaces. Springer Series in Surface Sciences Vol. 27, Springer (Berlin) 1992,
- D. Farias and K.H. Rieder, Rep. Prog. Phys. 61, 1575 (1998)
- L. Lichtenstein, M. Heyde, and H.-J.Freund. Crystalline-vitreous interface in two dimensional silica. Physical Review Letters, 109:106101, 2012
- S. J. H. Petra, K. A. H. Van Leeuwen, L. Feenstra, W. Hogervorst, W. Vassen. Atom lithography with two-dimensional optical masks. Applied Physics B, 79:279283, 2004
- K. G. H. Baldwin. Metastable helium: atom optics with nano-grenades. Contemporary Physics, 46:105120, 2005
- K. K. Berggren, A. Bard, J. L Wilbur, J. D. Gillaspy, A. Helg, J. J. Mcclelland, S. L. Rolston, W. D. Phillips, M. Prentiss, G. M. Whitesides. Microlithography by using neutral, metastable atoms and self-assemble monolayers. Science, 269: 1255, 1995
- S. Nowak, T. Pfau, J. Mlynek: Nanolitohgraphy with metastable helium. Appl. Phys. B., 63: 203, 1996
- S. Rehse, A. Glueck, S. A. Lee, A. B. Goulaov, C. S. Menoni, D. C. Ralph, K. S. Johnson and M. Prentiss: Nanolithography with metastable neon atoms: Enhanced rate of contamination resist formation for nanostructure fabrication. Appl. Phys. Lett., 71: 1427, 1997
- P. Engels, S. Salewski, H. Levsen, K Sengstock and W. Ertmer: Atom Lithography with a cold, metastable neon beam. Appl. Phys. B., 69: 407, 1999
- M. Kueis, F. Lison, D. Haubrich, D. Meschede, S. Nowak, T. Pfau, J. Mlynek: Pattern generation with cesium atomic beams at nanometer scales. Appl. Phys. B., 63: 649, 1996
- E. Arimondo:. Laser controlled nanodeposition of neutral atoms. Appl. Surf. Sci., 248: 167, 2005
- A. Camposeu, O. Marago, B. Fazio, B. Kloeter, D. Meschede, U. Rasbach, C. Weber and E. Arimondo: Resist-assisted atom lithography with group III elements. Appl. Phys. B. 85: 487, 2006
- C. S Allred, Neutral atom lithography with metastable helium, Ph.D. Dissertation, Stone Brook University 2009, UMI Dissertation Publishing United States, UMI Number 3388553
- M. Born, E. Wolf: Principles of Optics, Pergamon Press, 1970
- Y. Xia, Z. M Zhao,E. Kim and G. Whitesides: A selective etching solution for use with patterned self-assembled monolayers of alkanethiolates on gold. Chem. Mater., 7: 2332, 1995
- K. S: Johnson, K. K. Berggren, A. Black, C.T. Black, A. P. Chu, N. H. Dekker, D. C. Ralph, J. H. Thywissen, R. Younkin, M. Tinkham, M. Prentiss and G. M. Whitesides. Using neutral metastable argon atoms and contamination lithography to form nanostructure in silicon, silicon dioxide and gold. Appl. Phys. Lett. 69: 2773, 1996
- S. B. Hill, C. A. Haich, F. B. Dunning, G. K Walters, J. J. McClelland, R. J. Celotta, H. G. Craighead, J. Han and D. M. Tannenbaum: Patterning of octadecylsiloxane self-assembled monolayers on Si (100) using Ar(3P0,2) atoms. J. Vac. Sci. Technol. B, 17: 1087, 1999
- W. Lu, K. Baldwin, M. Hoogerland, S. Buckman, T. J. Senden, T. E: Sheridan, R. W. Boswell: Sharp edged silicon structures generated using atom lithography with metastable helium atoms. J. Vac. Sci. Technol. B, 16:3846, 1998
- J. Zhang, M. Kurahashi, T. Suzuki, X. Sun, Y. Yamuchi: Microfabrication of silicon using self-assembled monolayer resist and metastable helium beam. Jpn. J. Appl. Phys., 45(10A): 8020, 2006
- R. Sanz, M. Jaafar, M. Hernandez-Velez, A. Asenjo, M. Vázquez, J. Jensen: Patterning of rutile TiO2 surface by ion beam lithography through full-solid masks. Nanotechnology, 21: 235301, 2010

## Claims

1. A method of forming a desired pattern on a substrate comprising the steps of
a) generating an atomic or molecular beam;
b) providing a mask having a desired pattern;
c) directing the atomic or molecular beam through the patterned mask onto a substrate, whereby a pattern is formed on the substrate by interaction with the proportion of the atomic or molecular beam which penetrates through the mask, which pattern is based on the pattern of the mask,
wherein the patterned mask is prepared by a method comprising
d) providing a porous starting mask material having openings of a size which allow the atomic or molecular beam to penetrate through;
e) creating the desired pattern on the mask by filling a proportion of the openings of the mask which thereby become non-transparent for the atomic or molecular beam.

2. The method according to claim 1, wherein the atomic or molecular beam generated in step (a) comprises one of the following: He atoms or any other noble gas atoms, in particular metastable noble gas atoms, H₂ molecules, N₂ molecules, or energetic neutral atoms, in particular oxygen or nitrogen atoms, preferably He atoms, in particular metastable He atoms.

3. The method according to claim 1 or claim 2, wherein the atomic beam generated in step (a) has a spatial coherence length corresponding to the extension of the mask and a wavelength distribution which is small relative to the pore size of the mask.

4. The method according to any one of the preceding claims, wherein the substrate is subjected to one or more further processing steps subsequent to step (c), for example one or more chemical treatment steps such as etching.

5. The method according to any one of the preceding claims, wherein the substrate comprises one or more resist layers for creating the desired pattern by interaction with the proportion of the atomic or molecular beam which penetrates through the mask and, optionally, one or more intermediate layers such as metal layers.

6. The method according to any one of the preceding claims, wherein the proportion of the resist layer(s) that has interacted with the proportion of the atomic or molecular beam which penetrates through the mask and, optionally, the one or more intermediate layers is/are subjected to etching.

7. The method according to claim 5 or claim 6, wherein the resist layer is a hydrophobic resist layer comprises organic molecules sensitive to interaction with the proportion of the atomic or molecular beam which penetrates through the mask, preferably wherein the resist layer comprises self-assembled monolayers of organic molecules such as thioles, for example nonanethiol or dodecanethiol.

8. The method according to any one of the preceding claims, wherein the substrate is selected from the group consisting of semiconductors, glass materials metals and combinations thereof such as silicon wafers.

9. The method according to any one of the preceding claims, wherein the starting mask material is selected from the group consisting of graphene, silicates having a channel structure, for example SiO₂, beryl, zeolites, zircon or other types of sheet- or framework- or neo-silicates, metal-organic frameworks, two-dimensional porous protein crystals, mesoporous silica, anodic aluminium oxide, and other oxides and glasses such as silicate and network glasses.

10. The method according to any one of the preceding claims, wherein the starting mask material is prepared by one of the following:
i) thinning down of bulk materials by mechanical polishing and/or chemical polishing and/or sputtering followed by patterning or alternatively first patterning and then thinning down;
ii) the creation of free standing thin films in a Langmuir Blodgett or similar fashion;
iii) the growth of a thin film on a substrate, wherein the substrate is removed before or after creating the desired pattern according to step (e) of claim 1;
iv) the pulling of bundles of glass capillary tubes followed by thinning down by mechanical polishing and/or chemical polishing and/or sputtering followed by patterning or alternatively first patterning and then thinning down.

11. The method according to any one of the preceding claims, wherein focussed ion beam induced deposition or focussed electron beam induced deposition or focussed ion deposition or scanning probe lithography is used for filling a proportion of the openings contained in the starting mask material thereby creating the desired pattern.

12. The method according to any one of the preceding claims, wherein the size of the openings in the starting mask material is in the range from Angstrom to micrometer.

13. The method according to any one of the preceding claims, wherein the starting mask material is based on a quartz film grown on the surface of a metallic substrate, preferably a single-crystalline metallic substrate in particular on the (0001) surface of a noble metal such as ruthenium.

14. The method according to any one of the preceding claims, wherein the desired pattern of the mask is a Fourier transformation of the desired pattern on the substrate.

15. The method according to any one of the preceding claims, wherein the method is used for preparing conducting circuit structures (micro-chips) or microelectromechanical systems (MEMS) or structures for micro/nano fluidics or nanostructured surfaces, ie. hydrophobic or hydrophilic surfaces or reflective/antireflective surfaces.

## Patentansprüche

1. Verfahren zur Ausbildung eines gewünschten Musters auf einem Substrat, umfassend die Schritte von
a) Erzeugen eines atomaren oder molekularen Strahls;
b) Bereitstellen einer Maske, die ein gewünschtes Muster aufweist;
c) Lenken des atomaren oder molekularen Strahls durch die gemusterte Maske auf ein Substrat, wodurch auf dem Substrat durch Wechselwirkung mit dem Anteil des atomaren oder molekularen Strahls, der durch die Maske dringt, ein Muster ausgebildet wird, das auf dem Muster der Maske beruht,
wobei die gemusterte Maske durch ein Verfahren gefertigt wird, das
d) Bereitstellen eines porösen Maskenausgangsmaterials aufweisend Öffnungen mit einer Größe, die das Hindurchdringen des atomaren oder molekularen Strahls ermöglicht;
e) Erzeugen des gewünschten Musters auf der Maske durch Füllen eines Anteils der Öffnungen der Maske umfasst, die dadurch für den atomaren oder molekularen Strahl undurchsichtig werden.

2. Verfahren nach Anspruch 1, wobei der in Schritt (a) erzeugte atomare oder molekularen Strahl eines umfasst von: He-Atomen oder beliebigen anderen Edelgasatomen, insbesondere metastabile Edelgasatome, H₂-Moleküle, N₂-Moleküle, oder energetische neutrale Atome, insbesondere Sauerstoff- oder Stickstoffatome, bevorzugt He-Atome, insbesondere metastabile He-Atome.

3. Verfahren nach Anspruch 1 oder Anspruch 2, wobei der in Schritt (a) erzeugte Atomstrahl eine räumliche Kohärenzlänge, die der Ausdehnung der Maske entspricht, und eine Wellenlängenverteilung aufweist, die im Verhältnis zur Porengröße der Maske klein ist.

4. Verfahren nach einem der vorstehenden Ansprüche, wobei das Substrat im Anschluss an Schritt (c) einem oder mehreren weiteren Bearbeitungsschritten unterzogen wird, z. B. einem oder mehreren chemischen Behandlungsschritten wie Ätzen.

5. Verfahren nach einem der vorstehenden Ansprüche, wobei das Substrat eine oder mehrere Fotolackschichten zur Erzeugung des gewünschten Musters durch Wechselwirkung mit dem Anteil des atomaren oder molekularen Strahls, der durch die Maske dringt, und optional eine oder mehrere Zwischenschichten wie Metallschichten umfasst.

6. Verfahren nach einem der vorstehenden Ansprüche, wobei der Anteil der Fotolackschicht(en), der mit dem Anteil des atomaren oder molekularen Strahls, der durch die Maske dringt, in Wechselwirkung getreten ist, und optional die eine oder mehrere Zwischenschichten einer Ätzung unterzogen wird/werden.

7. Verfahren nach Anspruch 5 oder Anspruch 6, wobei die Fotolackschicht eine hydrophobe Fotolackschicht ist, die organische Moleküle umfasst, die empfindlich auf Wechselwirkung mit dem Anteil des atomaren oder molekularen Strahls reagieren, der durch die Maske dringt, wobei die Fotolackschicht bevorzugt selbstorganisierte Monoschichten aus organischen Molekülen wie Thiolen, zum Beispiel Nonanethiol oder Dodecanethiol, umfasst.

8. Verfahren nach einem der vorstehenden Ansprüche, wobei das Substrat ausgewählt ist aus der Gruppe bestehend aus Halbleitern, Glasmaterialien, Metallen und Kombinationen davon, wie zum Beispiel Siliziumwafern.

9. Verfahren nach einem der vorstehenden Ansprüche, wobei das Maskenausgangsmaterials ausgewählt ist aus der Gruppe bestehend aus Graphen, Silikaten mit einer Kanalstruktur, zum Beispiel SiO₂, Beryll, Zeolithen, Zirkon oder anderen Arten von Platten- oder Gerüst- oder Neosilikaten, metallorganischen Gerüsten, zweidimensionalen porösen Proteinkristallen, mesoporösem Siliziumdioxid, anodischem Aluminiumoxid und anderen Oxiden und Gläsern wie Silikat- und Netzwerkgläsern.

10. Verfahren nach einem der vorstehenden Ansprüche, wobei das Maskenausgangsmaterial durch einen der folgenden Schritte hergestellt wird:
i) Ausdünnen von Bulk-Materialien durch mechanisches Polieren und/oder chemisches Polieren und/oder Sputtern, gefolgt von Musterung oder alternativ zuerst Musterung und dann Ausdünnen;
ii) Herstellung von freistehenden Dünnschichten nach dem Langmuir-Blodgett-Verfahren oder einem ähnlichen Verfahren;
iii) Aufwachsen einer Dünnschicht auf einem Substrat, wobei das Substrat vor oder nach der Erzeugung des gewünschten Musters gemäß Schritt (e) von Anspruch 1 entfernt wird;
iv) Ziehen von Glaskapillarrohrbündeln und anschließendes Ausdünnen durch mechanisches Polieren und/oder chemisches Polieren und/oder Sputtern und anschließende Musterung oder alternativ zuerst Musterung und dann Ausdünnen.

11. Verfahren nach einem der vorstehenden Ansprüche, wobei die fokussierte ionenstrahlinduzierte Abscheidung oder die fokussierte elektronenstrahlinduzierte Abscheidung oder die fokussierte lonenabscheidung oder die Rastersondenlithographie zum Füllen eines Teils der in dem Maskenausgangsmaterial enthaltenen Öffnungen verwendet wird, wodurch das gewünschte Muster erzeugt wird.

12. Verfahren nach einem der vorstehenden Ansprüche, wobei die Größe der Öffnungen im Maskenausgangsmaterial im Bereich von Angström bis Mikrometer liegt.

13. Verfahren nach einem der vorstehenden Ansprüche, wobei das Maskenausgangsmaterial auf einem Quarzfilm basiert, der auf der Oberfläche eines metallischen Substrats, bevorzugt eines einkristallinen metallischen Substrats, insbesondere auf der (0001)-Oberfläche eines Edelmetalls wie Ruthenium, aufgewachsen ist.

14. Verfahren nach einem der vorstehenden Ansprüche, wobei das gewünschte Muster der Maske eine Fourier-Transformation der gewünschten Maske auf dem Substrat ist.

15. Verfahren nach einem der vorstehenden Ansprüche, wobei das Verfahren zur Herstellung von leitenden Schaltungsstrukturen (Mikrochips) oder mikroelektromechanischen Systemen (MEMS) oder Strukturen für die Mikro-/Nanofluidik oder nanostrukturierten Oberflächen, d. h. hydrophoben oder hydrophilen Oberflächen oder reflektierenden/antireflektierenden Oberflächen, verwendet wird.

## Revendications

1. Procédé de formation d'un motif souhaité sur un substrat, comprenant les étapes consistant à
a) générer un faisceau d'atomes ou de molécules ;
b) fournir un masque présentant un motif souhaité ;
c) diriger le faisceau d'atomes ou de molécules à travers le masque à motif jusque sur un substrat, un motif étant par là-même formé sur le substrat par interaction avec la proportion du faisceau d'atomes ou de molécules qui pénètre à travers le masque, lequel motif est basé sur le motif du masque,
dans lequel le masque à motif est préparé selon un procédé comprenant les étapes consistant à
d) fournir un matériau de masque de départ poreux présentant des ouvertures d'une taille qui permet au faisceau d'atomes ou de molécules de pénétrer à travers celles-ci ;
e) créer le motif souhaité sur le masque en remplissant une proportion des ouvertures du masque qui deviennent ainsi non transparentes pour le faisceau d'atomes ou de molécules.

2. Procédé selon la revendication 1, dans lequel le faisceau d'atomes ou de molécules généré dans l'étape (a) comprend certains parmi : des atomes de He ou de quelconques autres atomes de gaz noble, en particulier des atomes de gaz noble métastables, des molécules de H₂, des molécules des N₂, ou des atomes neutres énergétiques, en particulier des atomes d'oxygène ou d'azote, de préférence des atomes de He, en particulier des atomes de He métastables.

3. Procédé selon la revendication 1 ou la revendication 2, dans lequel le faisceau d'atomes généré dans l'étape (a) présente une longueur de cohérence spatiale correspondant à l'extension du masque et une distribution de longueur d'onde qui est petite par rapport à la taille de pore du masque.

4. Procédé selon l'une quelconque des revendications précédentes, dans lequel le substrat est soumis à une ou plusieurs étapes de traitement ultérieures à l'étape (c), par exemple une ou plusieurs étapes de traitement chimique, comme une gravure.

5. Procédé selon l'une quelconque des revendications précédentes, dans lequel le substrat comprend une ou plusieurs couches de réserve pour créer le motif souhaité par interaction avec la proportion du faisceau d'atomes ou de molécules qui pénètre à travers le masque et, facultativement, une ou plusieurs couches intermédiaires comme des couches métalliques.

6. Procédé selon l'une quelconque des revendications précédentes, dans lequel la proportion de la ou des couches de réserve qui a interagi avec la proportion du faisceau d'atomes ou de molécules qui pénètre à travers le masque et, facultativement, les une ou plusieurs couches intermédiaires est/sont soumise(s) à une gravure.

7. Procédé selon la revendication 5 ou la revendication 6, dans lequel la couche de réserve est une couche de réserve hydrophobe comprenant des molécules organiques sensibles à une interaction avec la proportion du faisceau d'atomes ou de molécules qui pénètre à travers le masque, de préférence dans lequel la couche de réserve comprend des monocouches auto-assemblées de molécules organiques comme des thiols, par exemple nonanethiol ou dodécanethiol.

8. Procédé selon l'une quelconque des revendications précédentes, dans lequel le substrat est sélectionné dans le groupe consistant en des semi-conducteurs, des métaux de matériau de verre, et des combinaisons de ceux-ci, comme des plaquettes de silicium.

9. Procédé selon l'une quelconque des revendications précédentes, dans lequel le matériau de masque de départ est sélectionné dans le groupe consistant en du graphène, des silicates présentant une structure de canal, par exemple du SiO₂, du béryle, des zéolithes, du zircon ou d'autres types de silicates en feuille ou de structure ou de néosilicates, des structures organométalliques, des cristaux de protéine poreux bidimensionnels, de la silice mésoporeuse, de l'oxyde d'aluminium anodique, et d'autres oxydes et verres comme du silicate et des verres en réseau.

10. Procédé selon l'une quelconque des revendications précédentes, dans lequel le matériau de masque de départ est préparé par l'une des étapes suivantes :
i) un amincissement de matériaux en vrac par polissage mécanique et/ou polissage chimique et/ou pulvérisation cathodique, suivi d'une formation de motif ou, en variante, d'une première formation de motif puis d'un amincissement ;
ii) la création de films minces autoportants de Langmuir Blodgett ou d'une manière similaire ;
iii) la croissance d'un film mince sur un substrat, dans lequel le substrat est retiré avant ou après la création du motif souhaité selon l'étape (e) de la revendication 1 ;
iv) le tirage de faisceaux de tubes capillaires en verre suivi d'un amincissement par un polissage mécanique et/ou un polissage chimique et/ou une pulvérisation cathodique suivis d'une formation de motif ou, en variante, d'une première formation de motif puis d'un amincissement.

11. Procédé selon l'une quelconque des revendications précédentes, dans lequel un dépôt induit par un faisceau d'ions focalisé ou un dépôt induit par un faisceau d'électrons focalisé ou un dépôt d'ions focalisé ou une lithographie par sonde de balayage est utilisé(e) pour remplir une proportion des ouvertures contenues dans le matériau de masque de départ, en créant ainsi le motif souhaité.

12. Procédé selon l'une quelconque des revendications précédentes, dans lequel la taille des ouvertures dans le matériau de masque de départ est dans la plage d'Angström à micromètre.

13. Procédé selon l'une quelconque des revendications précédentes, dans lequel le matériau de masque de départ est à base d'un film de quartz mis à croître sur la surface d'un substrat métallique, de préférence un substrat métallique monocristallin, en particulier sur la surface (0001) d'un métal noble comme le ruthénium.

14. Procédé selon l'une quelconque des revendications précédentes, dans lequel le motif souhaité du masque est une transformation de Fourier du motif souhaité sur le substrat.

15. Procédé selon l'une quelconque des revendications précédentes, dans lequel le procédé est utilisé pour préparer des structures de circuit conductrices (micro-puces) ou des systèmes microélectromécaniques (MEMS) ou des structures pour des micro/nano-éléments fluidiques ou des surfaces nanostructurées, c'est-à-dire des surfaces hydrophobes ou hydrophiles ou des surfaces réfléchissantes/antiréfléchissantes.
